(19) Europäisches Patentamt
European Patent Office
Office européen des brevets

(11) **EP 3 407 493 A1**

(12) **EUROPEAN PATENT APPLICATION**

(43) Date of publication:
**28.11.2018 Bulletin 2018/48**

(51) Int Cl.:
**H03K 17/04** $^{(2006.01)}$      **H03K 17/732** $^{(2006.01)}$

(21) Application number: **17290067.2**

(22) Date of filing: **22.05.2017**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicant: **General Electric Technology GmbH 5400 Baden (CH)**

(72) Inventors:
• **Yang, Yang**
  **69100 Villeurbanne (FR)**
• **Dupraz, Jean-Pierre**
  **01360 Bressolles (FR)**

(74) Representative: **Fischer, Michael Maria et al General Electric Technology GmbH GE Corporate Intellectual Property Brown Boveri Strasse 7 5400 Baden (CH)**

(54) **THYRISTOR BLOCKING CIRCUIT AND METHOD OF BLOCKING A THYRISTOR**

(57) The invention relates to a high-power thyristor blocking circuit, comprising a high-power thyristor (1) having an anode (A), a cathode (K) and a gate (G), a gate driver (M) configured to control the gate of the thyristor (1); and a circuit configured to apply a negative voltage ($V_{AK}$) between the anode and the cathode of the thyristor (1), wherein the gate driver (M) is configured to apply a negative voltage ($V_{GK}$) between the gate and the cathode of thyristor (1) after the lapse of a predetermined delay time from a time that the voltage ($V_{AK}$) between the anode and the cathode has become negative.

FIG. 1

EP 3 407 493 A1

## Description

## TECHNICAL FIELD

The invention relates to high power thyristors and related technologies, such as for example Gate Turn-Off Thyristors (GTOs) or other components based on the same principle and identified through their commercial names such as SGTOs or others. All these similar components will be hereafter designed by "Thyristors". The invention proposes a high power thyristor blocking device and a corresponding method.

A particular application of the invention is a mechatronic circuit breaker device as disclosed in EP 12 810 269.

## PRIOR ART

A thyristor is a semiconductor device provided with three terminals: an anode and a cathode acting as main terminals and a gate acting as a control terminal. The blocking operation of a thyristor is usually achieved by applying a reverse voltage across the component, thereby making the anode negative with respect to the cathode. As a consequence, the current flowing from the anode to the cathode will decrease, and then continue to swing negative into a reverse bias conducting condition under the application of reverse voltage. Reverse current will continue to flow until all the excess space charge is removed from the thyristor. Most of the energy required to remove the space charges is provided by the power circuit in which the component is installed.

After such a blocking operation, the thyristor cannot withstand the reapplication of a positive voltage, where the anode is positive with respect to the cathode, until sufficient time has elapsed to ensure a complete elimination of the space charges. Therefore, a time period Tq is necessary between the instant when the anode current becomes zero and the time when the thyristor can withstand the reapplied positive voltage. This time interval Tq, referred to as the turn-off time, may be of the order of several hundred microseconds for a high-power thyristor. In practice, the switching time of a thyristor depends on the turn-off time Tq and it is difficult to achieve very low turn-off time values for physical and manufacturing reasons.

A Gate Turn-Off thyristor (GTO) is advantageous over a conventional thyristor in that it may be turned off without requiring the inversion of the anode-cathode voltage. The blocking of a GTO component is traditionally achieved by generating a strong negative current in the gate for a sufficient period of time to evacuate the space charges stored in the internal junctions of the component. The drawback of such a GTO is the complexity of the gate control circuit, as the energy required to block the thyristor through its gate can be very high.

For example, blocking a GTO conducting a current of 3000A may require the discharge, via the gate, of an electric charge of several tens of milli Coulombs. For example, to evacuate a load Qgq via a gate pulse of triangular shape, with peak amplitude Igqm and duration tgq, the amplitude of the required trigger current is given approximately by:

$$I_{gqm} = 2 \cdot \frac{Q_{gq}}{t_{gq}}$$

Thus, the evacuation of a load Qgq of 20 mC over a time period of 20$\mu$s will require a trigger pulse with an amplitude of at least 2000A, which is considerable for a control circuit. As a result, the trigger control circuit can be very complex.

These constraints have led to a new family of components, Integrated Gate-Commutated Thyristors (IGCTs), comprising a combination of a GTO and its pre-wired control electronics. Although such components simplify the design of the trigger control circuit, and reduce somewhat the power supply required for the control circuit, power requirements still present difficulties. Power is generally delivered via an auxiliary source galvanically isolated from the control circuit(s). Isolation, provided by transformers or voltage converters, generally allows a few kilovolts to be held, rather than tens of kilovolts.

Such components are therefore not easy to use at very high voltages when the potential difference between the control circuits and the auxiliary sources responsible for delivery of power is several hundred kilovolts. This constitutes a severe limitation of this type of component which can be used within high voltage DC circuit breakers where components are required to withstand voltages of several hundred kV.

It is known, for example in DE 19711438, to reduce thyristor turn-off time Tq during manufacture by reducing the lifetime of the minority carriers of the semiconductors. This is conventionally carried out by irradiating the semiconductors with particles such as heavy metals or electrons/protons in a radiation furnace. However, such irradiation is an expensive additional procedure during manufacture and may have detrimental effects on the component, such as: increased voltage drop, reduced nominal thyristor power, increased latching current and increased gate energy required for closing.

Hence, although such irradiation makes it possible to reduce the turn-off time Tq of the thyristor, overall thyristor performance may be compromised, which is not acceptable in certain applications.

The object of the present invention is to provide a thyristor blocking device that alleviates some or all the drawbacks of the prior art referred to above.

In particular, the object of the present invention is to provide a thyristor blocking device which reduces significantly the turn-off time Tq and the power required by the control circuit to ensure turn-off of the thyristor.

## STATEMENT OF THE INVENTION

The present invention provides a high-power thyristor blocking circuit, comprising a high-power thyristor having an anode, a cathode and a gate, a gate driver connected to the thyristor and configured to control the gate of the thyristor and a circuit configured to apply a negative voltage between the anode and the cathode of the thyristor, wherein the gate driver is configured to apply a negative voltage between the gate and the cathode of thyristor after the lapse of a predetermined delay time from a time that the voltage between the anode and the cathode has become negative.

The configuration of the present invention advantageously reduces the turn-off time Tq of the thyristor and the power required for the control circuit to ensure blocking of the thyristor compared to existing blocking arrangements.

According to a preferred embodiment, the gate driver is connected to the anode, the cathode and the gate of the thyristor, and comprises a sensor configured to detect when the voltage between the anode and the cathode becomes negative, a clock configured to be triggered on detection of the voltage between the anode and the cathode becoming negative by the sensor; and a turn-off switch module configured to be triggered by clock on elapse of the predetermined delay time, and to connect the gate and the cathode of thyristor via a module that is configured to apply a negative voltage between the gate and the cathode of thyristor.

According to another preferred embodiment, the predetermined delay time is selected such that the negative voltage is applied between the gate and the cathode of thyristor before the voltage between the anode and the cathode becomes positive again. In addition, the predetermined delay time is preferably greater than the time required to remove the thyristor space charge by the negative voltage applied between the anode and the cathode.

The circuit configured to apply a negative voltage between the anode and cathode of thyristor preferably comprises a first voltage surge limiter and a first capacitor connected in parallel, wherein both the first voltage surge limiter and the first capacitor are connected in series with thyristor. The circuit further includes a switch and a second capacitor connected in series, the second capacitor connected in parallel with a discharge resistor, wherein the circuit comprising the switch and the second capacitor is connected in parallel with a circuit comprising the thyristor and the first voltage surge limiter. Finally, the circuit also includes a second voltage surge limiter connected in parallel with the circuit comprising thyristor and the first voltage surge limiter.

According to a preferred embodiment, the clamping voltage of the second voltage surge limiter is lower than the withstand voltage of thyristor. In another preferred embodiment, the clamping voltage of the first voltage surge limiter is lower than the clamping voltage of the second voltage surge limiter.

In another preferred embodiment, the module that is configured to apply a negative voltage between the gate and the cathode of thyristor comprises a storage capacitor that has been previously charged by the circuit configured to apply a negative voltage between the anode and the cathode of the thyristor.

The voltage between the anode and the cathode of thyristor is preferably negative for a time period of less than or equal to 100 $\mu$s.

The present invention further resides in a method for blocking a high-power thyristor, the thyristor comprising an anode, a cathode and a gate, the method comprising the steps of applying a negative voltage between the anode and the cathode of the thyristor, detecting when the voltage between the anode and the cathode of thyristor becomes negative, after the closing of the thyristor and applying a negative voltage between the gate and the cathode of thyristor after the elapse of a predetermined delay time from detection of the voltage between the anode and the cathode of thyristor becoming negative.

## BRIEF DESCRIPTION OF THE DRAWINGS

Other advantages and features of the invention become more clearly apparent on reading the detailed description given with reference to the following figures, in which:

Figure 1 shows a thyristor blocking circuit according to an embodiment of the invention;
Figure 2 shows a gate driver comprised in the thyristor blocking circuit, according to an embodiment of the invention;
Figure 3a shows the state of a commutation switch comprised in the thyristor blocking circuit, as a function of time, according to an embodiment of the invention;
Figure 3b shows the curve of the current flowing between the anode and the cathode of the thyristor, as a function of time, according to an embodiment of the invention;
Figure 3c shows the curve of the voltage between the terminals of a voltage surge limiter comprised in the thyristor blocking circuit, as a function of time, according to an embodiment of the invention;
Figure 3d shows the curve of the voltage between the anode and the cathode of the thyristor, as a function of time, according to an embodiment of the invention;
Figure 3e shows the voltage output of a sensor which detects that the voltage between the anode and the cathode of the thyristor becomes negative, as a function of time, according to an embodiment of the invention;
Figure 3f shows the control of a voltage applied between the gate and the cathode of the thyristor, as a function of time, according to an embodiment of the invention;

Figure 3g shows the curve of the voltage between the terminals of a storage capacitor of the gate driver, as a function of time, according to an embodiment of the invention;

Figure 3h shows the curve of the voltage between the gate and the cathode of the thyristor, as a function of time, according to an embodiment of the invention; and

Figure 4 shows a method for controlling the thyristor, according to an embodiment of the invention.

## DETAILED DESCRIPTION OF PARTICULAR EMBODIMENTS

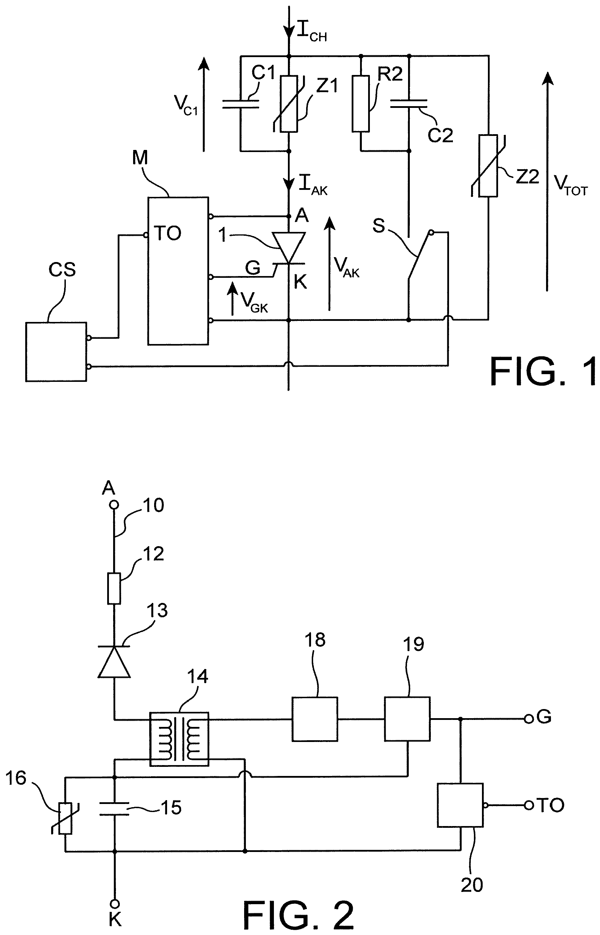

Figure 1 illustrates a high power thyristor blocking device according to an embodiment of the invention.

It should be noted that in order to simplify the description of the invention, only those components essential to the present invention are described herein. Other components, well known to the person skilled in the art and required in practical applications, such as, for example, inductances for limiting current variation rates, or snubbers for limiting voltage variation rates are not described.

A high power thyristor 1 comprises an anode A, a cathode K and a gate G. An auxiliary circuit comprising a first voltage surge limiter Z1, a first capacitor C1, a commutation switch S, a second capacitor C2, a discharge resistor R2 and a second voltage surge limiter Z2, is provided and is configured to impose a negative voltage between the anode and the cathode.

The first voltage surge limiter Z1 and the first capacitor C1 are connected in parallel to each other and form a thyristor switch circuit that is connected in series with thyristor 1. In this example, the thyristor switch circuit is connected to the anode A of the thyristor 1. The withstand voltage of thyristor 1 is higher than the clamping voltage $V_{Z1}$ of first voltage limiter Z1.

The commutation switch S and the second capacitor C2 are connected in series and form a commutation circuit that is connected in parallel with the thyristor switch circuit and thyristor 1. The commutation switch S may be, for example, a thyristor-based switch or a triggered spark gap switch. The second capacitor C2 is connected in parallel with a discharge resistor R2.

The second voltage surge limiter Z2 is connected in parallel with the commutation circuit and is configured to clamp the transient overvoltage across the thyristor blocking device when the current is interrupted. The clamping voltage of the second voltage surge limiter Z2 is lower than the withstand voltage of thyristor 1 and is higher than the clamping voltage of the first voltage limiter Z1.

A gate driver M is connected to the anode A, the gate G and the cathode K of the thyristor 1 and is configured to control the voltage and the current of the gate of the thyristor so as to ensure conduction of the thyristor by generation of a positive gate current.

According to the present invention, during the blocking phase of the thyristor, the gate driver M is also configured to detect when the voltage $V_{AK}$ between the anode A and cathode K of thyristor 1 becomes negative, and to apply a negative voltage $V_{GK}$ between the gate G and cathode K of the thyristor 1 after an appropriate time period.

A control system CS is connected to the gate driver M and to the commutation switch S by control lines and is configured to generate control signals for closing the thyristor 1 and the commutation switch S, respectively.

Figure 2 shows an embodiment of the gate driver M. The gate driver M comprises a capacitor pathway 10 connected in parallel with the thyristor 1 between the anode A and cathode K thereof. The capacitor pathway 10 comprises at least a low voltage module connected in series with a high voltage module. The low voltage module comprises at least a low voltage capacitor 15 connected in parallel with at least a voltage surge limiter 16, while the high voltage module comprises at least a diode 13 connected in series with a resistor 12.

The gate driver M also comprises a current sensor 14, such as a transformer. The primary winding of the transformer 14 is connected in series with the components of the capacitor pathway 10 of the gate driver M, between the low voltage module and the high voltage module. The secondary winding of the transformer 14 is connected between a clock 18 and the cathode K of thyristor 1. The clock 18 is connected to a control input of a turn-off switch module 19 which is connected between the low voltage module and the gate G of thyristor 1.

A turn-on driver 20 is connected between the cathode K and the gate G of the thyristor and is configured to be controlled by the control system CS to turn-on thyristor 1.

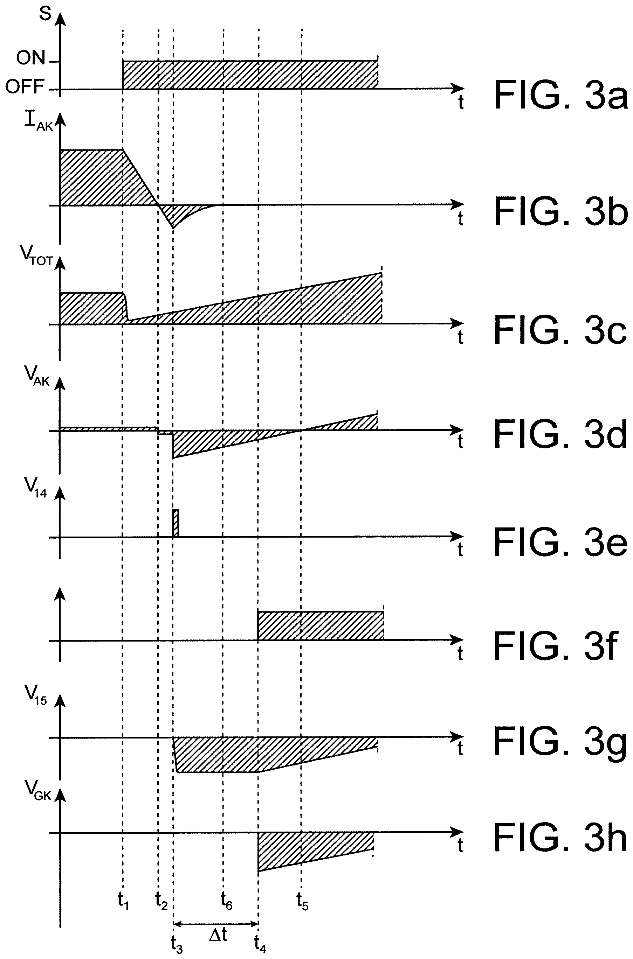

Figure 3a shows the state of the commutation switch S as a function of time. During a first time period ending at time t1, commutation switch S is open. The blocking sequence of thyristor 1 starts by control system CS sending a command to commutation switch S at time t1 to turn on. The closing time of the commutation switch S is assumed to be negligible.

Figure 3b shows the current $I_{AK}$ flowing between the anode A and the cathode K of the thyristor 1, as a function of time. Before switching on of commutation switch S at time t1, a main current $I_{CH}$ passes through thyristor 1 and the current $I_{AK}$ is equal to the main current $I_{CH}$. Capacitor C2 is discharged via resistor R2. During the blocking sequence, due to its discharged state, capacitor C2 forms a short circuit, and the voltage $V_{c1}$ between the terminals of the capacitor C1 is applied inversely to the terminals of thyristor 1. The main current $I_{CH}$ progressively flows towards the capacitor C2 due to stray inductances in the circuit loop, in series with thyristor 1 and commutation switch S.

As shown in Figure 3b, the current $I_{AK}$ between the anode and cathode of thyristor 1 begins to decrease rapidly from time t1, becoming zero at time t2 and reaching a maximum negative amplitude at time t3. After time t3, current $I_{AK}$ increases and tends towards zero, while remaining negative.

Figure 3c shows the characteristic of the total voltage $V_{TOT}$, between the terminals of the second voltage surge limiter Z2, as a function of time. Before time t1, the total voltage $V_{TOT}$ is constant. Following commencement of the blocking sequence at time t1, total voltage $V_{TOT}$ abruptly reduces to near zero and then increases almost linearly up to the clamping voltage of the second voltage surge limiter Z2.

Figure 3d shows the characteristic of voltage $V_{AK}$ between the anode A and the cathode K of the thyristor 1, as a function of time. When the current $I_{AK}$ is positive, the voltage $V_{AK}$ equals the voltage drop across the thyristor 1 which is close to zero. Between times t2 when $I_{AK}$ becomes negative and t3 when $I_{AK}$ reaches its negative extreme, voltage $V_{AK}$ remains close to zero. At time t3, voltage $V_{AK}$ becomes negative and decreases rapidly until it reaches a maximum negative amplitude, subsequently increasing at a rate given by

$$\frac{dV_{AK}}{dt} = \frac{I_{CH}}{C_2}$$

where $I_{CH}$ is the main current passing through thyristor 1 before switching on of commutation switch S at time t1 and the value of the capacitor C2:

As shown in Figure 3d, the voltage $V_{AK}$ substantially follows the characteristic of the voltage $V_{TOT}$ as shown in figure 3c. The negative voltage $V_{AK}$ is the reverse bias voltage of the thyristor and the time during which the voltage $V_{AK}$ is negative is the hold-off time $T_{HO}$ and is equal to the difference t5-t2.

The hold-off time $T_{HO}$ in this thyristor blocking device is given by the following equation:

$$T_{HO} = \frac{C_2 * V_{Z1}}{I_{CH}}$$

Hence, the hold-off time $T_{HO}$ is proportional to the capacitance of the second capacitor. Therefore, the capacitance of the second capacitor should be as small as possible in order to minimise $T_{HO}$, preferably less than or equal to 100 $\mu$s.

On the other hand, in order to avoid breakdown when a positive voltage is applied across the thyristor at time t5, the hold-off time $T_{HO}$ should be greater than the turn-off time Tq of the thyristor.

It should be noted that although times t2 and t3 will be very close to one another, time t3 may be easily detected by gate driver M due to the sudden change of the voltage $V_{AK}$ between the anode A and the cathode K of thyristor 1.

Figure 3e shows the voltage output $V_{14}$ of the sensor 14 which performs this detection, as a function of time. As shown, the voltage output $V_{14}$ of sensor 14 remains zero until time t3 when an inrush of current passes through the primary winding of transformer 14, generating a non-zero voltage output in the secondary winding thereof which triggers clock 18. This non-zero output voltage is positive in the described embodiment, but could be negative in other embodiments. The non-zero output voltage is generated for a short time and becomes zero again.

The gate driver M uses time t3 at which the voltage $V_{AK}$ becomes negative to determine the time at which to apply a negative voltage $V_{GK}$ between the gate G and the cathode K of the thyristor 1.

Figure 3f shows the control of the negative voltage applied between the gate G and the cathode K of the thyristor, as a function of time. At time t3, when the voltage $V_{AK}$ becomes negative, the gate driver activates clock 18 to determine a delay time $\Delta t$ before which a negative voltage $V_{GK}$ may be applied between the gate G and the cathode K of thyristor 1.

The time t3+$\Delta t$ at which the negative voltage $V_{GK}$ is applied must be prior to time t5 at which the voltage $V_{AK}$ becomes positive again. Accordingly, the following relation is verified: $\Delta t$ < t5-t3.

The delay time $\Delta t$ is preferably greater than the reverse recovery time of the thyristor when the thyristor space charge is evacuated by the reverse voltage applied by the auxiliary circuit. This evacuation is characterized as the presence of reverse current of thyristor 1. Accordingly, the following relation is verified: $\Delta t$ > t6-t3.

The clock 18 is triggered upon detection of a non-zero voltage in the secondary winding of the current sensor 14. After delay time $\Delta t$ has elapsed, (i.e., time t4), the clock 18 transmits a triggering signal to the turn-off switch module 19 to close it and the voltage that was stored by the capacitor 15, is applied between the gate and the cathode of thyristor 1, the gate being negative with respect to the cathode.

Figure 3g illustrates the characteristic of the voltage $V_{15}$ applied between the two terminals of the storage capacitor 15 of the gate driver M.

As shown, the voltage $V_{15}$ is zero until time t3 at which time voltage $V_{AK}$ becomes negative, and then decreases rapidly decreases rapidly until it reaches the clamping voltage of the voltage surge limiter 16. At time t4, when turn-off switch 19 is closed, the negative voltage of the storage capacitor 15 is applied between the gate G and cathode K of thyristor and the capacitor 15 discharges to evacuate the space charges remaining in the thyristor junctions. Therefore, the amplitude of the voltage $V_{15}$ decreases, but the voltage $V_{15}$ remains negative.

Figure 3h shows the characteristic of the voltage $V_{GK}$ between the gate and the cathode of thyristor 1, as a function of time. As shown, voltage $V_{GK}$ is near zero until time t4 when turn-off switch module 19 is closed and the negative voltage of the storage capacitor 15 is applied between the gate G and the cathode K of thyristor 1. The voltage $V_{GK}$ has therefore almost the same amplitude as voltage $V_{15}$.

According to the invention, the thyristor blocking sequence comprises two phases; a first phase corresponding to the time interval (t4-t1) and a second phase beginning at time t4.

During the first phase, the space charges are evacuated from thyristor 1 via a reverse current flowing between its cathode and its anode. This phase is similar to the reverse recovery phase of diodes and thyristors.

During the second phase, the negative voltage $V_{GK}$ is applied so that the gate G is at a negative potential with respect to the cathode K. During this second phase, the residual space charges "leave" the thyristor 1 via its gate G and almost none via its anode A. Since most of the charges have been evacuated during the first phase of operation, the energy required for the second phase is considerably lower than would have been necessary if the thyristor were locked via its gate only.

The voltage $V_{GK}$ is preferably maintained for a time interval longer than the time necessary for evacuating all the space charges. Indeed, the application of $V_{GK}$ for an extended time is useful to evacuate any space charges that are be added through the stray capacitance of thyristor by the circuit in which the thyristor is installed. This typically occurs when, after applying a reverse voltage between the anode and the cathode of the thyristor, the anode-cathode voltage increases almost linearly until it becomes positive again to reach a maximum value. During this increase of the anode-cathode voltage $V_{AK}$, the internal stray capacitances of the thyristor inject charges. The corresponding current is substantially proportional to the rate of increase of the anode-cathode voltage. The maintenance of a negative voltage between the anode and the cathode of the thyristor facilitates evacuation of the space charges caused by the stray capacitances and prevents untimely conduction of the thyristor.

The implementation of this technique, with an appropriate selection of delay time $\Delta t$, makes it possible to reduce significantly the turn-off time Tq of thyristor 1. According to the invention, the turn-off time of a very high power thyristor can be decreased well below 100 $\mu$s and even below 10 $\mu$s for particular components. This allows use of such components in applications requiring very short turn-off times or relatively high switching frequencies.

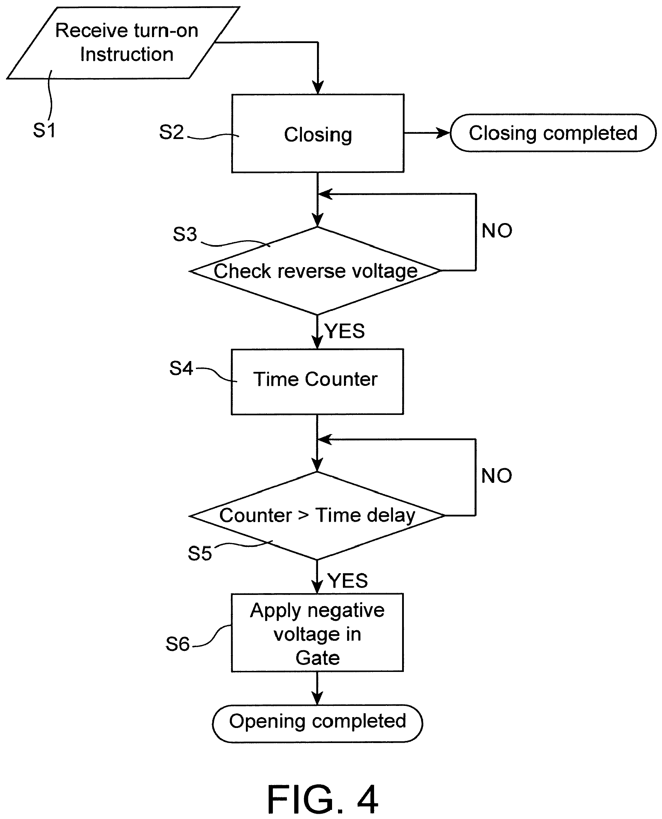

Figure 4 shows a method for controlling thyristor 1 implemented in the gate driver M described above. The method comprises steps S 1 to S6.

At Step S1, the gate driver M receives a control command from control system CS to turn-on.

The closing of the thyristor 1 is initiated at step S2 when turn-on driver 20 in gate driver M is activated causing an appropriate current to flow between the gate G and the cathode K of thyristor 1. Thyristor is now in its conduction mode and the turn-on phase thereof is completed.

In step S3, the polarity of the voltage $V_{AK}$ between the anode A and the cathode K of thyristor 1 is checked and for as long as voltage $V_{AK}$ is positive, step S3 is repeated.

If the voltage $V_{GK}$ becomes negative, step S4 is initiated, and clock 18 is triggered for a predetermined delay time $\Delta t$ in step S5. As described above, an appropriate selection of delay time $\Delta t$ allows the turn-off time Tq of thyristor 1 to be significantly reduced.

In Step S6, when the predetermined delay time $\Delta t$ has elapsed, a control command is sent to turn-off switch module 19 to close so as to generate a thyristor gate negative voltage $V_{GK}$. The turn-off of thyristor 1 is then completed.

**Claims**

1. A high-power thyristor blocking circuit, comprising:

   a high-power thyristor (1) comprising an anode (A), a cathode (K) and a gate (G);
   a gate driver (M) connected to the thyristor (1) and configured to control the gate of the thyristor (1); and
   a circuit configured to apply a negative voltage ($V_{AK}$) between the anode and the cathode of the thyristor (1),
   wherein the gate driver (M) is configured to apply a negative voltage ($V_{GK}$) between the gate and the cathode of thyristor (1) after the lapse of a predetermined delay time from a time that the voltage ($V_{AK}$) between the anode and the cathode has become negative.

2. A thyristor blocking circuit according to claim 1, wherein the gate driver (M) is connected to the anode (A), the cathode (K) and the gate (G) of the thyristor (1) and comprises
   a sensor (14) configured to detect when the voltage ($V_{AK}$) between the anode and the cathode becomes negative;
   a clock (18) configured to be triggered on detection of the voltage ($V_{AK}$) between the anode and the cathode becoming negative by the sensor (14); and
   a turn-off switch module (19) configured to be triggered by clock (18) on elapse of the predetermined delay time, and to connect the gate (G) and the cathode (K) of thyristor (1) via a module (15) that is configured to apply a negative voltage between the gate and the cathode of thyristor (1).

3. A thyristor circuit blocking according to claim 1 or 2, wherein the predetermined delay time is selected such that the negative voltage ($V_{GK}$) is applied between the gate and the cathode of thyristor (1) before the voltage ($V_{AK}$) between the anode and the cathode becomes positive again.

4.  A thyristor blocking circuit according to any of claims 1 to 3, wherein the predetermined delay time is greater than the time required to remove the thyristor space charge by the negative voltage applied between the anode and the cathode.

5.  A thyristor blocking circuit according to any of claims 1 to 4, wherein the circuit configured to apply a negative voltage between the anode and cathode of thyristor (1) comprises
a first voltage surge limiter (Z1) and a first capacitor (C1) connected in parallel, wherein both the first voltage surge limiter (Z1) and the first capacitor (C1) are connected in series with thyristor (1);
a switch (S) and a second capacitor (C2) connected in series, the second capacitor connected in parallel with a discharge resistor (R2), wherein the circuit comprising the switch (S) and the second capacitor (C2) is connected in parallel with a circuit comprising the thyristor (1) and the first voltage surge limiter (Z1); and
a second voltage surge limiter (Z2) connected in parallel with the circuit comprising thyristor (1) and the first voltage surge limiter (Z1).

6.  A thyristor blocking circuit according to claim 5, wherein the clamping voltage of the second voltage surge limiter (Z2) is lower than the withstand voltage of thyristor (1).

7.  A thyristor blocking circuit according to claim 5 or 6, wherein the clamping voltage of the first voltage surge limiter (Z1) is lower than the clamping voltage of the second voltage surge limiter (Z2).

8.  A thyristor blocking circuit according to any of claims 2 to 7, wherein the module (15) that is configured to apply a negative voltage between the gate and the cathode of thyristor (1) comprises a storage capacitor (15) which is previously charged by the circuit configured to apply a negative voltage between the anode and the cathode of the thyristor.

9.  A thyristor blocking circuit according to any of claims 1 to 8, wherein the voltage between the anode and the cathode of thyristor (1) is negative for a time period of less than or equal to 100 $\mu$s.

10. A method for blocking a high-power thyristor (1), the thyristor comprising an anode, a cathode and a gate, the method comprising the steps of:

applying a negative voltage ($V_{AK}$) between the anode and the cathode of the thyristor (1),

detecting when the voltage ($V_{AK}$) between the anode and the cathode of thyristor becomes negative, after the closing of the thyristor; and applying (S6) a negative voltage ($V_{GK}$) between the gate and the cathode of thyristor (1) after the elapse of a predetermined delay time from detection of the voltage ($V_{AK}$) between the anode and the cathode of thyristor becoming negative.

FIG. 1

FIG. 2

FIG. 3a

FIG. 3b

FIG. 3c

FIG. 3d

FIG. 3e

FIG. 3f

FIG. 3g

FIG. 3h

**FIG. 4**

Europäisches
Patentamt

European
Patent Office

Office européen
des brevets

# EUROPEAN SEARCH REPORT

**Application Number**

EP 17 29 0067

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 107 551 A (AKAMATSU MASAHIKO) 15 August 1978 (1978-08-15) * abstract * * column 3, line 19 - column 6, line 28; figures 1-3,6-19 * * column 7, line 19 - column 8, line 45 * ----- | 1-10 | INV. H03K17/04 H03K17/732 |
| X | US 3 943 430 A (KUMANO MASAYOSHI) 9 March 1976 (1976-03-09) * abstract * * column 10, line 3 - column 11, line 55; figures 17a,18d * ----- | 1-10 | |
| A | JP S54 39561 A (MITSUBISHI ELECTRIC CORP) 27 March 1979 (1979-03-27) * the whole document * ----- | 1-10 | |

TECHNICAL FIELDS
SEARCHED      (IPC)

H03K

The present search report has been drawn up for all claims

| Place of search | Date of completion of the search | Examiner |
|---|---|---|
| The Hague | 16 November 2017 | João Carlos Silva |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

......................................................................................
& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 17 29 0067

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2017

| Patent document cited in search report | | Publication date | Patent family member(s) | | Publication date |
|---|---|---|---|---|---|
| US 4107551 | A | 15-08-1978 | NONE | | |
| US 3943430 | A | 09-03-1976 | NONE | | |
| JP S5439561 | A | 27-03-1979 | JP | S5439561 A | 27-03-1979 |
| | | | JP | S5932011 B2 | 06-08-1984 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 12810269 A
- DE 19711438